# FASCICULE DE BREVET EUROPEEN

(11) **EP 3 714 666 B1**
(45) Date de publication et mention de la délivrance du brevet: **07.06.2023**
(21) Numéro de dépôt: 18803677.6
(22) Date de dépôt: 17.11.2018
(51) Int. Cl.: H05K 7/14

(54) **PROCEDE D'INSERTION, VERROUILLAGE ET EXTRACTION DE MODULE ELECTRONIQUE ET STRUCTURE D'ACCUEIL DE MISE EN OEUVRE**
VERFAHREN ZUM EINSETZEN, VERRIEGELN UND HERAUSZIEHEN EINES ELEKTRONISCHEN MODULS UND GEHÄUSESTRUKTUR ZUR DURCHFÜHRUNG DES VERFAHRENS
METHOD FOR INSERTING, LOCKING AND EXTRACTING AN ELECTRONIC MODULE AND HOUSING STRUCTURE FOR IMPLEMENTING SAME

(30) Priorité: 20.11.2017 FR 1760899
(43) Date de publication de la demande: 30.09.2020
(73) Titulaire: Latelec, 31670 Labege Occitanie (FR)
(72) Inventeur: BOUSQUET, Jean,François, 31150 Brugieres Occitanie (FR); PUERTOLAS, Bastien, 31280 AIGREFEUILLE (FR)
(74) Mandataire: Junca, Eric
(86) Numéro de dépôt international: PCT/EP2018/081662
(87) Numéro de publication internationale: WO 2019/097040

(56) Documents cités:
- EP-A1- 1 084 597
- EP-A1- 2 542 042
- FR-A1- 3 038 203
- US-A1- 2005 174 743
- US-A1- 2008 045 051
- US-B1- 6 406 312

## Description

### DOMAINE TECHNIQUE

L'invention se rapporte à un procédé d'insertion, de verrouillage et d'extraction de module électronique, ainsi que d'une structure d'accueil de tels modules équipée d'un système d'insertion, de verrouillage et d'extraction de tels modules de mise en oeuvre de ce procédé. L'invention se rapporte également à une baie avionique constituée d'un ensemble de structures d'accueil de ce type et destinée à connecter des équipements électriques/électroniques via des câblages répartis dans un aéronef, ainsi qu'à l'aéronef comportant une telle baie avionique.

L'invention concerne l'organisation de la connectique du traitement et de la gestion électrique/électronique d'équipements de type mécanique (valves, pompes, etc.) ou électrique/électronique (coeurs électriques, calculateurs, capteurs de navigation, convertisseurs, batteries, etc.), dans les domaines du transport, en particulier de l'aéronautique, du spatial ou de l'informatique.

La connectique est en général réalisée à partir de modules électroniques (« blades » en terminologie anglaise), intégrant des cartes et des composants électroniques, et qui sont conditionnés sous forme de boitiers minces dans une structure d'accueil pour y être aisément remplacés. Les modules amovibles sont appelés LRU (« line replaceable unit » en terminologie anglaise) ou LRM (« line replaceable module » en terminologie anglaise) selon qu'ils concernent un équipement dans son entier ou un sous-ensemble de cet équipement.

Chaque structure d'accueil se compose de logements individuels disposés parallèlement les uns aux autres pour recevoir en position verticale chacun des modules et se présente sous forme de rack, meuble, cabinet ou armoire selon leur dimension. Les structures d'accueil sont également équipées d'ouvertures de ventilation pour aérer les modules amovibles. Dans le cas d'un aéronef, l'ensemble des structures d'accueil constitue une baie avionique.

Chaque module amovible est muni sur une face arrière d'au moins une fiche de connexion pouvant s'accoupler ou se désaccoupler dans une interface de connexion à une ou à des prises de connexion associée(s), intégrées à une paroi de fond dite « fond de panier » de la structure d'accueil. Dans un aéronef, la baie avionique est connectée à travers cette interface, directement ou par connexion inter-blades, à différents équipements opérationnels répartis dans l'aéronef selon une architecture réseau, via des harnais de faisceaux de câbles électriques/optiques, ainsi qu'un réseau d'alimentation électrique de bord.

Une baie avionique est de préférence localisée dans la partie inférieure avant du fuselage, sous le cockpit, dans des conditions de pression et de température contrôlées. Des structures mécaniques sont avantageusement prévues dans la zone d'accueil de la baie pour assurer un maintien des structures d'accueil en liaison avec leur environnement immédiat et aménager un passage pour les flux d'air de ventilation de ces structures d'accueil. Ces structures mécaniques obéissent pour les LRU à la norme ARINC série 600: un assemblage équipé de moyens de verrouillage conforme à cette norme est par exemple décrit dans le document de brevet US 6 797 879.

### ÉTAT DE LA TECHNIQUE

L'augmentation et la diversification des équipements entraînent l'apparition de câblages et de connexions de configuration et de nature variées (par exemple électrique ou optique). Afin de faciliter l'insertion et l'extraction des modules tout en préservant une bonne connexion des liaisons électriques, des solutions ont été développées à partir de moyens d'insertion, d'extraction et de verrouillage montés sur les modules électroniques ou sur les structures d'accueil.

On connaît par exemple du document EP 2 542 042 un dispositif de verrouillage de cartes électroniques dans un cabinet. Chaque carte électronique est insérée dans un boitier équipé de deux leviers, un levier d'extraction et un levier de verrouillage. Ces leviers s'étendent sur le plateau inférieur du châssis du cabinet et sont mobiles en rotation autour d'axes latéraux parallèles à la façade du châssis. L'extrémité du levier d'extraction est configurée pour venir en butée sur une extension du levier de verrouillage, de sorte qu'il est impossible de poursuivre un mouvement conjoint des leviers et de manipuler ainsi les leviers dans un ordre inadapté.

Le document EP 1 084 597 divulgue un autre mécanisme également monté sur le module électronique. Ce mécanisme comporte un double levier relié à une poignée unique, l'ensemble étant monté sur ressort pour rattraper les jeux et appliquer un effort de maintien en position verrouillée.

D'autres systèmes sont agencés sur le bâti de la structure d'accueil. Dans cette catégorie, le document EP 3 008 983 décrit une poignée unique pivotante exerçant un double mouvement du boitier du meuble d'accueil: d'abord un mouvement latéral de mise en position transversal sur un côté du meuble, puis un mouvement de translation perpendiculaire au mouvement latéral pour l'insertion du module vers l'arrière du meuble.

Cependant, ces systèmes d'insertion, verrouillage et extraction génèrent l'application d'un effort important à l'insertion et à l'extraction du fait du nombre élevé de contacts à gérer au niveau de l'interface de connexion. La présence de mécanismes de démultiplication est donc ajoutée pour réduire cet effort.

En outre, les systèmes connus sont tous montés au niveau de la face avant des modules ou des structures d'accueil. Ceci génère une augmentation de la masse : le chemin d'effort, pour assurer l'accouplement du module au connecteur, transite sur toute sa profondeur et celle de sa structure d'accueil. Ainsi, la structure du module et celle de la structure d'accueil sont alors dimensionnées pour tenir ces efforts, d'où l'augmentation de masse.

De plus, ces systèmes connus nécessitent une maîtrise de la position des deux connecteurs - ceux des modules et ceux du fond de panier - pour assurer une bonne interface d'accouplement. Ainsi, une chaîne de cotes complexe passant par le module, la structure d'accueil, les deux connecteurs et le système d'insertion est à mettre en oeuvre par des usinages et assemblages précis. Alternativement, un dispositif de rattrapage de jeux à ressort complexe - décrit par exemple dans le document EP 1 084 597 cité ci-dessus - ou un mécanisme de serrage nécessitant une procédure de contrôle spécifique de type verrou ARINC - comme dans le document US 6 797 879 déjà cité - peuvent être utilisés.

Par ailleurs, il est connu d'ajouter un mécanisme sur ressort dit en « bottoming » (c'est-à-dire en position de fond) pour la mise en place et le maintien en position des connecteurs comme décrit dans le document US 2008045051. Ce mécanisme réalise un effort permanent garantissant un contact dans les conditions d'utilisation.

L'évolution du format des modules de nouvelle génération tend en général vers une épaisseur plus réduite et un rapport hauteur/profondeur plus élevé. Cette évolution impose une répartition des efforts d'insertion et d'extraction sur toute la hauteur. Ainsi, pour permettre une manipulation sans arcboutement, le système présente deux points d'action par deux leviers ou poignées, en partie haute et basse, manipulés à deux mains générant un risque d'erreur de manipulation. Alternativement, un seul levier ou poignée peut être utilisée via un mécanisme intégrant deux points d'activation. Là encore, les mécanismes sont complexes et ajoutent du poids.

### EXPOSÉ DE L'INVENTION

L'invention vise à permettre l'insertion, l'extraction et le verrouillage de modules électroniques en réduisant la masse et la complexité du système au regard des solutions existantes, par une manipulation en une seule opération, sans outil ni réglage, avec un verrouillage automatique du module. En outre, l'invention reste compatible avec un montage de fond de panier de type bottoming et de formats variés de module.

Pour ce faire, l'invention prévoit d'agir non pas sur le module ou sa structure d'accueil au plus près de l'opérateur, mais directement au plus près de l'interface de connexion par l'exercice d'un effort à l'arrière du module.

Plus précisément, la présente invention a pour objet un procédé d'insertion, de verrouillage et d'extraction de module électronique en connexion réversible avec un fond de panier d'une structure d'accueil configuré en logements individuels pour chacun des modules électroniques. Ce procédé consiste à actionner les étapes suivantes pour le verrouillage de chaque module électronique:
- introduire le module électronique dans un logement individuel jusqu'à libérer et déclencher un début de pivotement d'un levier démultiplicateur d'effort par une liaison mobile formée entre une extrémité distale dudit levier démultiplicateur montée en rotation sur le fond de panier et le module électronique;
- exercer une pression sur ledit levier à partir d'une extrémité proximale de ce levier pour poursuivre le pivotement du levier, déplacer le module électronique contre le fond de panier par l'orientation de la liaison mobile et connecter le module électronique au fond de panier par un passage des efforts d'insertion dans une interface de connexion;
- achever le pivotement du levier pour atteindre une position de verrouillage automatique de son extrémité proximale par déclenchement d'un mécanisme de verrouillage;
et, pour l'extraction de chaque module électronique:
- agir sur le mécanisme de verrouillage pour déverrouiller l'extrémité proximale du levier, pivoter le levier dans le sens inverse de celui du verrouillage pour déconnecter le module électronique par passage des efforts de désaccouplement dans l'interface de connexion, et avancer le module électronique dans son logement avant de retirer le module électronique.

Selon des formes de mise en oeuvre avantageuses:
- les états de verrouillage et de déverrouillage du levier sont validés par des indications visuelles différentes sur le mécanisme de verrouillage automatique;
- la liaison mobile entre l'extrémité distale du levier et le module électronique est formée par un chemin de guidage;
- le bras de levier présente une élasticité suffisante et/ou le chemin de guidage une forme incurvée adaptée à la connexion du module au fond de panier (« bottoming »), pour atteindre le verrouillage tout en continuant à être abaissé; même après connexion le chemin de guidage comporte en extrémité une zone souple de retenue réversible lorsque l'extrémité proximale du levier est en position de verrouillage.

L'invention concerne également une structure d'accueil de modules électroniques équipée d'un système d'insertion, de verrouillage et d'extraction de tels modules de mise en oeuvre du procédé défini ci-dessus. Une telle structure d'accueil comporte des logements individuels adjacents séparés par des glissières latérales et un fond de panier muni de connecteurs de câblage, chaque logement étant destiné à accueillir un module électronique. Dans cette structure d'accueil, le système d'insertion, de verrouillage et d'extraction comporte un bras de levier par logement individuel muni en une extrémité distale de moyens de pivotement sur le fond de panier et de moyens de guidage aptes à coopérer avec des moyens de circulation liés au module électronique pour accoupler des connecteurs du module électronique aux connecteurs du fond de panier, ainsi que des moyens de verrouillage / déverrouillage automatique en position relevée et de verrouillage automatique / déverrouillage en position abaissée d'une extrémité proximale de chaque bras de levier.

Selon des caractéristiques préférées :
- les états de verrouillage et de déverrouillage du bras de levier en position abaissée sont validés par un indicateur visuel via une ouverture formée sur une face d'extrémité proximale biseautée du bras de levier en fonction de la position du mécanisme de verrouillage automatique comportant un pêne couplé de façon libérable au plateau inférieure entre une position de verrouillage et une position de déverrouillage;
- le mécanisme de verrouillage / déverrouillage automatique du bras de levier en position relevée comporte des moyens de maintien libérables sous pression du poussoir à bille;
- le levier est constitué en un matériau suffisamment souple, en particulier en alliage d'acier ou en titane recouvert d'élastomère, pour servir de butée élastique à la saillie;
- les moyens de guidage comportent un chemin de came dans lequel une saillie est apte à circuler, cette saillie étant choisie entre, un ergot, un pion et un galet;
- chaque bras de levier est composé de deux branches destinées à encadrer chaque face latérale d'un module électronique.

### PRÉSENTATION DES FIGURES

D'autres données, caractéristiques et avantages de la présente invention apparaîtront à la lecture de la description non limitée qui suit, en référence aux figures annexées qui représentent, respectivement :
- la figure 1, une vue en perspective d'un exemple de rack d'accueil de modules électroniques selon l'invention lors de l'introduction d'un module;
- la figure 1a, une vue en coupe du mécanisme de maintien libérable d'un bras de levier du système d'insertion, de verrouillage et d'extraction du rack selon la figure 1;
- la figure 1b, une vue arrière partielle du module électronique introduit dans le rack d'accueil de la figure 1;
- la figure 2, une vue en perspective d'un rack selon la figure 1 lors du pivotement dudit bras de levier après décrochage;
- la figure 3, une vue en perspective d'un rack selon la figure 1 lors du verrouillage dudit bras de levier;
- les figures 4 et 4a, une vue en perspective d'un rack selon la figure 1 lors du déverrouillage du bras de levier et de début de pivotement dudit bras après déverrouillage;
- la figure 5, une vue en perspective d'un rack selon la figure 1 après déverrouillage et remise en position d'accrochage dudit bras;
- la figure 6, une vue en perspective d'un rack selon la figure 1 lors de l'extraction du module électronique avec accrochage du bras de levier;
- les figures 7a à 7c, une vue latérale partielle du fond de panier du rack selon la figure 1 montrant trois positions de l'ergot du module électronique dans le chemin de came du bras de levier lors de l'insertion et la connexion dudit module dans ledit fond de panier.

### DESCRIPTION DÉTAILLÉE

Dans le présent texte, les qualificatifs « supérieur » et « inférieur », et leurs dérivés ou équivalents, se rapportent à des positions relatives de parties d'éléments dans des configurations d'utilisation standard, en particulier aux positions relatives relevée et abaissée des bras de levier selon l'invention. Le qualificatif « latéral » se rapporte à des faces ou parois perpendiculaires aux faces avant ou de fond.

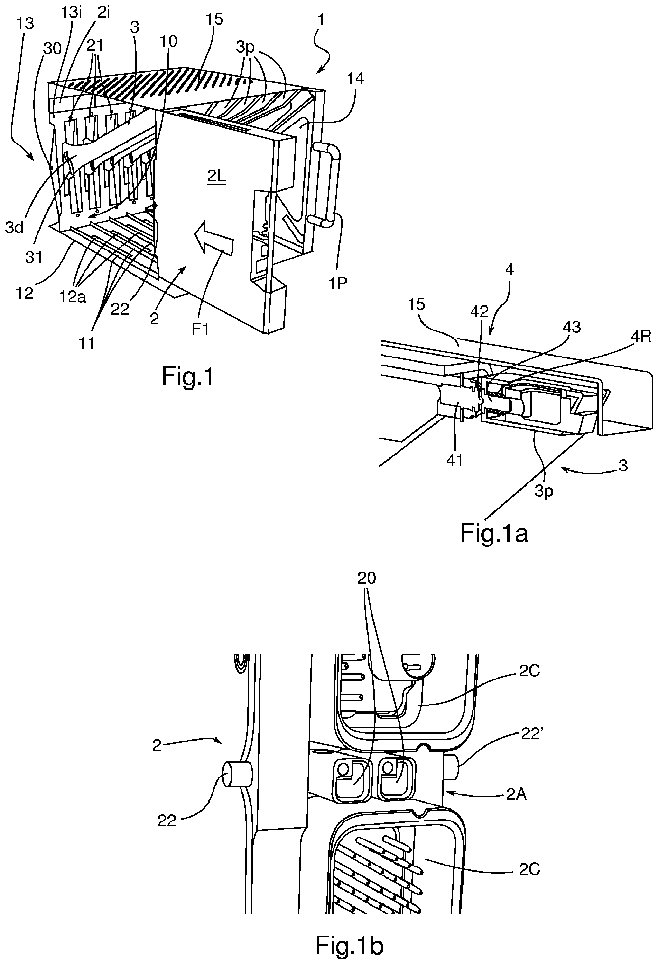

La vue en perspective de la figure 1 illustre un exemple de rack d'accueil parallélépipédique 1 de modules électroniques selon l'invention tel que le module 2. Une partie du rack 1 a été supprimée pour montrer l'introduction (flèche F1) du module électronique 2 au premier plan. Ce rack 1 comporte des logements individuels 10 pour modules électroniques, alignés de manière adjacente et séparés par des glissières 11 s'étendant le long d'un plateau inférieur 12. Le rack 1 se compose également d'un fond de panier 13 équipé de connecteurs alignés 21 sur sa face interne 13i, chaque connecteur 21 étant destiné à s'accoupler à des connecteurs arrière 2C (cf. figure 1b) d'un module tel que le module électronique 2, et deux parois latérales 14 (une seule étant visible sur la figure 1) munies de poignées de manutention 1P.

Le rack 1 accueille également une carte d'interconnexion 2i entre les modules électroniques 2. Les cartes d'interconnexion 2i se composent de circuits imprimés nommés « backplanes ». Ces « backplanes » 2i sont montés sur la face interne 13i de la structure de fond de panier 13, au-dessus et/ou au-dessous des connecteurs 21. Le rack 1 et l'insertion des modules avec un tel rack assurent également la mise en position et le maintien de chaque module 2 par rapport à ces backplanes 2i. De plus, le rack 1 est muni d'orifices 12a sur chaque logement individuel 10 au niveau de son plateau inférieur 12, permettant le passage d'un flux d'air pour refroidir les modules 2 une fois installés.

Selon l'invention, chaque logement de module 10 est équipé d'un bras de levier 3 s'étendant latéralement et muni, en une extrémité distale 3d, d'un orifice (non visible) coopérant avec un tourillon de rotation 30 fixé au fond de panier 13. Cette extrémité distale 3d est également munie d'un chemin de came 31 apte à permettre la circulation d'un ergot 22 monté de manière rotative en bordure d'une face latérale 2L du module électronique 2. Cet ergot 22 apparaît de manière détaillée sur la vue arrière partielle du module électronique 2 de la figure 1b. Alternativement, ou de manière cumulée, un ergot 22' fixé sur le connecteur 2C de la face arrière 2A du module électronique 2 apparaît également sur cette figure 1b. La circulation de l'ergot 22 dans le chemin de came 31 est destinée à permettre une connexion maîtrisée entre ce module 2 et le fond de panier 13, comme cela sera décrit de manière détaillée ci-après.

De plus, les connecteurs 2C du module 2 et les connecteurs 21 du fond de panier 13 sont ici munis de clefs de détrompage telles qu'illustrées par les éléments 20 du module 2 de la figure 1b. Ce détrompage empêche l'enfichage par erreur d'un module 2 au mauvais emplacement dans le rack 1. En cas d'erreur, le bras de levier 3 ne se présente pas à l'opérateur même s'il pousse le module 2 au fond de son emplacement. Avantageusement, le chemin de came 31 de par sa forme n'accueille l'ergot 22 qu'une fois la zone de détrompage franchie. Ainsi, le bras de levier 3 n'est automatiquement abaissé, pour pouvoir être manipulé, qu'à la condition que le bon module 2 soit positionné au bon emplacement dans le rack 1.

Chaque bras de levier 3 est maintenu en position relevée sur le plateau supérieur 15 du rack 1 par un mécanisme libérable 4 illustré par la vue en coupe de la figure 1a. Ce mécanisme de maintien libérable 4 comporte un poussoir à bille 41, monté sur le plateau supérieur 15. L'extrémité proximale 3p du bras de levier 3 comporte une encoche sphérique 43 qui permet un maintien libérable de ce bras de levier 3 en position relevée par un contact de cette encoche 43 contre la bille 42 sous la force du poussoir à bille 41.

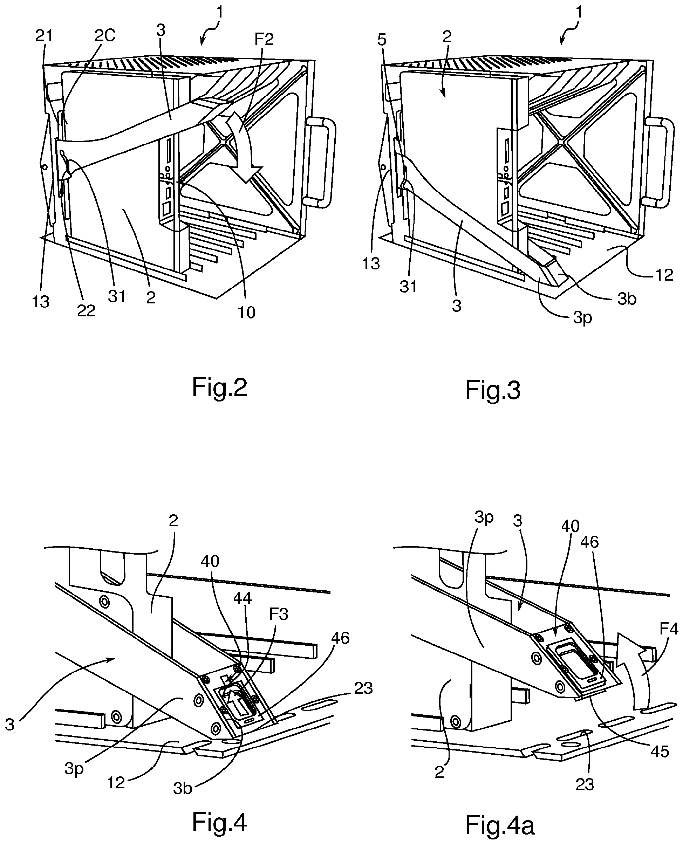

Comme illustré par la vue en perspective de la figure 2, l'avancée du module électronique 2 dans son logement 10 (flèche F1 de la figure 1) induit l'entrée de l'ergot 22 de ce module 2 dans le chemin de came 31. La poursuite de l'avancée du module 2 est alors enclenchée par le basculement du bras de levier 3 effectué par l'opérateur (flèche F2). Ce basculement provoque l'avancée de l'ergot 22 dans le chemin de came 31 et l'accouplement des connecteurs 2C du module 2 et du connecteur 21 du fond de panier 13 par passage des efforts d'insertion démultipliés dans l'interface de connexion commun formé entre ces connecteurs 2C et 21.

Lorsque le bras de levier 3 atteint le plateau inférieur 12 (figure 3), un mécanisme de verrouillage automatique / déverrouillage à ressort, qui sera décrit ci-dessous en référence aux figures 4 et 4a, fixe de manière réversible l'extrémité proximale 3p du bras de levier 3 au plateau inférieur 12. La connexion entre le module électronique 2 et le fond de panier 13 est alors bloquée grâce à une butée 5 formée à l'extrémité au chemin de came 31. Avantageusement, l'opérateur est informé de la position de verrouillage du module électronique 2 par le dépôt préalable d'une couche de couleur verte sur une face d'extrémité proximale biseautée 3b du bras de levier 3 via une ouverture 46.

Selon une cinématique inverse, l'extraction du module électronique 2 du rack 1 commence par une étape de déverrouillage de l'extrémité proximale 3p du bras de levier 3, comme montré en référence à la figure 4. Pour ce faire, l'opérateur exerce une force d'extraction sur un élément creux 44 (flèche F3) en liaison avec le mécanisme à ressort de verrouillage / déverrouillage 40 intégré à l'extrémité proximale 3p du bras 3 (ce mécanisme 40 est vu par transparence). Cette force fait coulisser (flèche F3) un pêne 45 (cf. figure 4a) hors d'une fente 23 du plateau inférieur 12, permettant à l'opérateur de libérer faire basculer le bras 3. L'ouverture 46 de la face d'extrémité biseautée 3b du bras de levier 3 fait alors apparaître, du fait de la nouvelle position du mécanisme de verrouillage / déverrouillage 40, une couche de couleur rouge déposée sur une face du mécanisme de verrouillage / déverrouillage 40. Dans une deuxième étape illustrée par En référence à la figure 4a, l'extrémité proximale 3p du bras de levier 3 est remontée pivotée (flèche F4) après sortie du pêne 45 hors de la fente 23 dans laquelle il était logé.

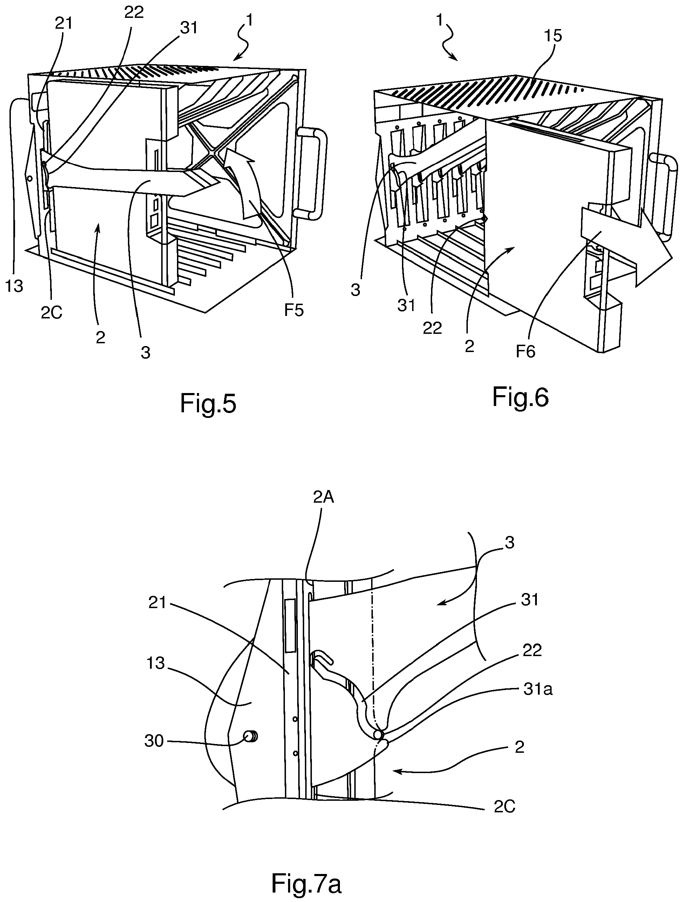

La poursuite de la remontée du bras de levier 3 est illustrée par la figure 5. Pendant cette remontée (flèche F5), l'ergot 22 se déplace dans le chemin de came 31 selon la trajectoire inverse, alors que simultanément les connecteurs 2C et 21, respectivement du module électronique 2 et du fond de panier 13, se détachent dans un mouvement continu. Lorsque le bras de levier 3 est de nouveau maintenu sur le plateau supérieur 15 (cf. figure 1b), l'ergot 22 est sorti du chemin de came 31 et le module électronique 2 est extrait par l'opérateur, comme illustré par la flèche F6 de la figure 6.

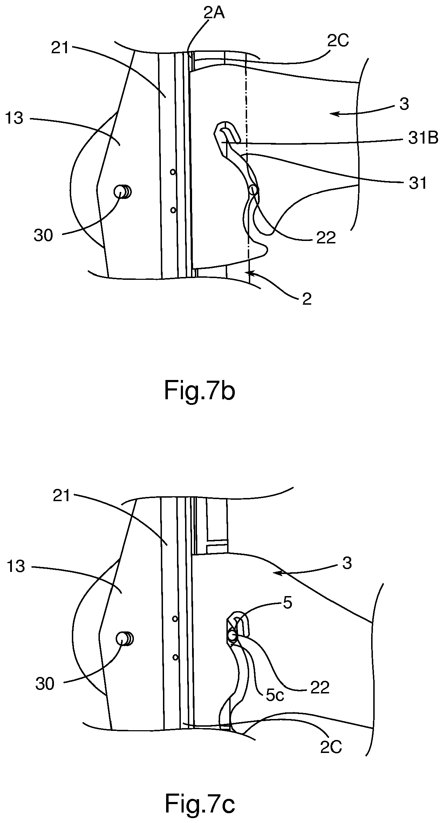

Le parcours de l'ergot 22 dans le chemin de came 31 lors de l'insertion jusqu'à la connexion du module électronique 2 dans le rack 1 est décrit ci-après en référence aux étapes de la vue en coupe latérale partielle des figures 7a à 7c. Sur ces figures, le chemin de came 31 présente une configuration en « S » et en son extrémité fermée 31b la butée 5 formant une retenue réversible pour l'ergot 22. Le bras de levier 3 peut pivoter en rotation par liaison au fond de panier 13 via le tourillon 30. Le chemin de came 31, le ou les ergots 22, 22' (figure 1b), les leviers 3 et leur mécanisme de pivotement à tourillon 30, le mécanisme de verrouillage automatique / déverrouillage 40 et le mécanisme de maintien libérable 4 des leviers 3 forment un exemple de système d'insertion, extraction et verrouillage selon l'invention.

En référence à la figure 7a, la position du bras de levier 3 correspond à l'entrée précise de l'ergot 22 dans l'extrémité ouverte 31a du chemin de came 31. Au fur et à mesure de l'abaissement du bras de levier 3, l'ergot 22 remonte dans le chemin de came 31 et le connecteur 2C de la face arrière 2A du module électronique 2 se rapproche du connecteur 21 du fond de panier 13 (figure 7b). Le bras de levier 3 est encore abaissé et, lorsqu'une légère poussée supplémentaire permet un blocage du bras de levier 3, l'ergot 22 est retenu de manière libérable dans un creux 5c formée par une butée élastique 5, les connecteurs 2C et 21 étant accouplés de manière précise et sûre. Alternativement le bras de levier 3 est constitué en un matériau suffisamment souple, un matériau plastique ou en alliage métallique recouvert d'une couche d'élastomère, pour pouvoir servir de butée élastique à l'ergot 22.

L'invention n'est pas limitée aux exemples de réalisation décrits et représentés. En particulier, le mécanisme de verrouillage automatique / déverrouillage peut être réalisé par tout moyen de rappel à ressort, à lame ou équivalent. En outre, alternativement au mode de réalisation illustré, les mécanismes de verrouillage automatique / déverrouillage et de maintien libérable des leviers peuvent être agencés respectivement sur le plateau inférieure et sur les bras de levier, les bras de levier peuvent être à simple ou double branche, les saillies de circulation dans les chemins de came peuvent être fixés sur les parois des modules ou sur les bras de levier et, réciproquement, les chemins de came peuvent être formés dans les bras de levier ou sur les parois des modules.

De plus, les chemins de came des bras de levier, les ergots de circulation dans ces chemins de came, les bras de levier et leur mécanisme de pivotement, le mécanisme de verrouillage automatique / déverrouillage et le mécanisme de maintien libérable des bras de levier et leurs variantes forment des exemples de systèmes d'insertion, extraction et verrouillage selon l'invention.

## Revendications

1. Procédé d'insertion, de verrouillage et d'extraction de module électronique (2) en connexion réversible avec un fond de panier (13) d'une structure d'accueil (1) configuré en logements individuels (10) pour chacun des modules électroniques (2), ce procédé est **caractérisé en ce qu'**il consiste à actionner les étapes suivantes pour le verrouillage de chaque module électronique (2):
- introduire le module électronique (2) dans un logement individuel (10) jusqu'à libérer et déclencher un début de pivotement d'un levier démultiplicateur d'effort (3) par une liaison mobile (31) formée entre une extrémité distale (3d) dudit levier démultiplicateur (3) montée en rotation (30) sur le fond de panier (13) et le module électronique (22, 22', 2);
- exercer une pression sur ledit levier (3) à partir d'une extrémité proximale (3p) de ce levier (3) pour poursuivre le pivotement du levier (3), déplacer le module électronique (2) contre le fond de panier (13) par l'orientation de la liaison mobile (22, 31) et connecter le module électronique (2) au fond de panier (13) par un passage des efforts d'insertion dans une interface de connexion;
- achever le pivotement du levier (3) pour atteindre une position de verrouillage automatique de son extrémité proximale (3p) par déclenchement d'un mécanisme de verrouillage (4);
et, pour l'extraction de chaque module électronique (2):
- agir sur le mécanisme de verrouillage (4) pour déverrouiller l'extrémité proximale (3p) du levier (3), pivoter le levier (3) dans le sens inverse de celui du verrouillage pour déconnecter le module électronique (2) par passage des efforts de désaccouplement dans l'interface de connexion, et avancer le module électronique (2) dans son logement (10) avant de retirer le module électronique (2).

2. Procédé d'insertion, de verrouillage et d'extraction selon la revendication 1, dans lequel les états de verrouillage et de déverrouillage du levier (3) sont validés par l'apparition d'indications visuelles différentes sur le mécanisme de verrouillage automatique (4).

3. Procédé d'insertion, de verrouillage et d'extraction selon l'une quelconque des revendications 1 ou 2, dans lequel la liaison mobile entre l'extrémité distale (3d) du levier et le module électronique (22, 22'; 2) est formée par un chemin de guidage (31).

4. Procédé d'insertion, de verrouillage et d'extraction selon l'une quelconque des revendications précédentes, dans lequel le bras de levier (3) présente une élasticité pour atteindre le verrouillage tout en continuant à être abaissé, même après connexion.

5. Structure d'accueil (1) de modules électroniques (2) équipée d'un système d'insertion, de verrouillage et d'extraction de tels modules (2) de mise en oeuvre du procédé selon l'une quelconque des revendications précédentes, une telle structure d'accueil (1) comportant des logements individuels adjacents (10) séparés par des glissières latérales (11) et un fond de panier (13) muni de connecteurs de câblage (21), chaque logement (10) étant destiné à accueillir un module électronique (2), cette structure est **caractérisée en ce que** le système d'insertion, de verrouillage et d'extraction comporte un bras de levier (3) par logement individuel (10) muni en une extrémité distale (3d) de moyens de pivotement (30) sur le fond de panier (13) et de moyens de guidage (31) aptes à coopérer avec des moyens de circulation (22, 22') liés au module électronique (2) pour accoupler des connecteurs (2C) du module électronique (2) aux connecteurs (21) du fond de panier (13), ainsi que des moyens de verrouillage / déverrouillage automatique en position relevée (41 à 43) et de verrouillage automatique / déverrouillage (40, 44, 45) en position abaissée d'une extrémité proximale (3p) de chaque bras de levier (3).

6. Structure d'accueil selon la revendication précédente, dans laquelle les états de verrouillage et de déverrouillage du bras de levier (3) en position abaissée sont validés par un indicateur visuel via une ouverture (45) formée sur une face d'extrémité proximale biseautée (3b) du bras de levier (3) en fonction de la position du mécanisme de verrouillage automatique (40) comportant un pêne (45) couplé de façon libérable au plateau inférieure (12) entre une position de verrouillage et une position de déverrouillage.

7. Structure d'accueil selon l'une quelconque des revendications 5 ou 6, dans laquelle le mécanisme de verrouillage / déverrouillage automatique (41 à 43) du bras de levier (3) en position relevée comporte des moyens de maintien libérables (41 à 43) sous pression d'un poussoir à bille (41).

8. Structure d'accueil selon l'une quelconque des revendications 5 à 7, dans laquelle le bras de levier (3) est constitué en un matériau souple servant de butée élastique à la saillie (22, 22').

9. Structure d'accueil selon l'une quelconque des revendications 5 à 8, dans laquelle les moyens de guidage comportent un chemin de came (31) dans lequel une saillie (22, 22') est apte à circuler, cette saillie (22, 22') étant choisie entre un ergot, un pion et un galet.

10. Structure d'accueil selon l'une quelconque des revendications 5 à 9, dans laquelle chaque bras de levier (3) est composé de deux branches destinées à encadrer chaque face latérale (2L) d'un module électronique (2).

11. Structure d'accueil selon l'une quelconque des revendications 5 à 9, dans laquelle les connecteurs (2C) de chaque module (2) et les connecteurs (21) du fond de panier (13) sont munis de clefs de détrompage (20).

12. Baie avionique d'aéronef constituée d'un ensemble de structures d'accueil (1) selon l'une quelconque des revendications 5 à 11 et destinée à connecter des équipements électriques/électroniques via des câblages répartis dans l'aéronef.

13. Aéronef comportant une baie avionique constituée d'un ensemble de structures d'accueil selon l'une quelconque des revendications 5 à 11, **caractérisé en ce que** les structures d'accueil (1) sont agencées sur des structures mécaniques de manière à permettre une circulation d'air entre eux et à transmettre des signaux de commande à des équipements électriques/électroniques de l'aéronef via des harnais de câblage électrique et/ou optique.

## Patentansprüche

1. Verfahren zum Einsetzen, Verriegeln und Herausziehen eines elektronischen Moduls (2) in einer reversiblen Verbindung mit einer Backplane (13) einer Gehäusestruktur (1), die als individuelle Aufnahmen (10) für jedes der elektronischen Module (2) konfiguriert ist, wobei dieses Verfahren **dadurch gekennzeichnet ist, dass** es für das Verriegeln jedes elektronischen Moduls (2) aus der Ausführung der folgenden Schritte besteht:
- Einführen des elektronischen Moduls (2) in eine individuelle Aufnahme (10), bis ein Beginn einer Schwenkbewegung eines Kraftuntersetzungshebels (3) durch eine bewegliche Verbindung (31) freigesetzt und ausgelöst wird, welche zwischen einem distalen Ende (3d) des Untersetzungshebels (3), der drehbar (30) an der Backplane (13) montiert ist, und dem elektronischen Modul (22, 22', 2) gebildet ist;
- Ausüben eines Drucks auf den Hebel (3) an einem proximalen Ende (3p) dieses Hebels (3), um die Schwenkbewegung des Hebels (3) fortzusetzen, Bewegen des elektronischen Moduls (2) gegen die Backplane (13) durch das Ausrichten der beweglichen Verbindung (22, 31) und Verbinden des elektronischen Moduls (2) mit der Backplane (13) durch ein Einleiten der Einsetzkräfte in eine Verbindungsschnittstelle;
- Abschließen der Schwenkbewegung des Hebels (3), um eine automatische Verriegelungsposition seines proximalen Endes (3p) durch Auslösung eines Verriegelungsmechanismus (4) zu erreichen;
und für das Herausziehen jedes elektronischen Moduls (2) aus der Ausführung der folgenden Schritte besteht:
- Einwirken auf den Verriegelungsmechanismus (4), um das proximale Ende (3p) des Hebels (3) zu entriegeln, Schwenken des Hebels (3) in der zu der Verriegelungsrichtung entgegengesetzten Richtung, um das elektronische Modul (2) durch Einleiten der Entkopplungskräfte in die Verbindungsschnittstelle zu trennen, und Vorziehen des elektronischen Moduls (2) in seiner Aufnahme (10) vor dem Entfernen des elektronischen Moduls (2).

2. Verfahren zum Einsetzen, Verriegeln und Herausziehen nach Anspruch 1, wobei die Verriegelungs- und Entriegelungszustände des Hebels (3) durch das Erscheinen von unterschiedlichen visuellen Anzeigen auf dem automatischen Verriegelungsmechanismus (4) bestätigt werden.

3. Verfahren zum Einsetzen, Verriegeln und Herausziehen nach einem beliebigen der Ansprüche 1 oder 2, wobei die bewegliche Verbindung zwischen dem distalen Ende (3d) des Hebels und dem elektronischen Modul (22, 22'; 2) durch eine Führungsbahn (31) gebildet ist.

4. Verfahren zum Einsetzen, Verriegeln und Herausziehen nach einem beliebigen der vorhergehenden Ansprüche, wobei der Hebelarm (3) eine Elastizität aufweist, um die Verriegelung während des fortlaufenden Absenkens, auch nach dem Verbinden, zu erreichen.

5. Gehäusestruktur (1) für elektronische Module (2), die über ein System zum Einsetzen, Verriegeln und Herausziehen solcher Module (2) zur Umsetzung des Verfahrens nach einem beliebigen der vorhergehenden Ansprüche verfügt, wobei eine solche Gehäusestruktur (1) aneinander angrenzende individuelle Aufnahmen (10), die durch seitliche Führungen (11) getrennt sind, und eine Backplane (13), die mit Kabelverbindern (21) ausgerüstet ist, umfasst, wobei jede Aufnahme (10) dazu bestimmt ist, ein elektronisches Modul (2) aufzunehmen, wobei diese Struktur **dadurch gekennzeichnet ist, dass** das System zum Einsetzen, Verriegeln und Herausziehen Folgendes umfasst: einen Hebelarm (3) pro individueller Aufnahme (10), der an einem distalen Ende (3d) über Mittel zum Schwenken (30) an der Backplane (13) und Mittel zum Führen (31) verfügt, welche dazu fähig sind, mit Zirkulationsmitteln (22, 22'), die mit dem elektronischen Modul (2) verbunden sind, zusammenzuwirken, um Verbinder (2C) des elektronischen Moduls (2) mit den Verbindern (21) der Backplane (13) zu koppeln, sowie Mittel zum automatischen Verriegeln/Entriegeln in der angehobenen Position (41 bis 43) und zum automatischen Verriegeln/Entriegeln (40, 44, 45) in der abgesenkten Position eines proximalen Endes (3p) jedes Hebelarms (3).

6. Gehäusestruktur nach dem vorhergehenden Anspruch, wobei die Verrieglungs- und Entriegelungszustände des Hebelarms (3) in der abgesenkten Position durch einen visuellen Anzeiger durch eine Öffnung (45), die an einer abgeschrägten proximalen Endfläche (3b) des Hebelarms (3) gebildet ist, bestätigt werden, in Abhängigkeit von der Position des automatischen Verriegelungsmechanismus (40), der einen Riegel (45) umfasst, der zwischen einer Verriegelungsposition und einer Entriegelungsposition lösbar mit der Bodenplatte (12) gekoppelt ist.

7. Gehäusestruktur nach einem beliebigen der Ansprüche 5 oder 6, wobei der Mechanismus (41 bis 43) zum automatischen Verriegeln/Entriegeln des Hebelarms (3) in der angehobenen Position Mittel zum lösbaren Halten (41 bis 43) unter der Druckeinwirkung eines Kugelstößels (41) umfasst.

8. Gehäusestruktur nach einem beliebigen der Ansprüche 5 bis 7, wobei der Hebelarm (3) aus einem flexiblen Material besteht, das dem Vorsprung (22, 22') als elastischer Anschlag dient.

9. Gehäusestruktur nach einem beliebigen der Ansprüche 5 bis 8, wobei die Führungsmittel eine Nockenbahn (31) umfassen, in der ein Vorsprung (22, 22') zirkulieren kann, wobei dieser Vorsprung (22, 22') aus einer Nase, einem Stift und einer Rolle ausgewählt ist.

10. Gehäusestruktur nach einem beliebigen der Ansprüche 5 bis 9, wobei jeder Hebelarm (3) aus zwei Schenkeln besteht, die dazu bestimmt sind, jede Seitenfläche (2L) eines elektronischen Moduls (2) einzurahmen.

11. Gehäusestruktur nach einem beliebigen der Ansprüche 5 bis 9, wobei die Verbinder (2C) jedes Moduls (2) und die Verbinder (21) der Backplane (13) über Unverwechselbarkeitsanschlüsse (20) verfügen.

12. Avionikraum eines Luftfahrzeugs, der aus einem Satz von Gehäusestrukturen (1) nach einem beliebigen der Ansprüche 5 bis 11 besteht und dazu bestimmt ist, elektrische/elektronische Ausrüstungen über in dem Luftfahrzeug verteilte Verkabelungen zu verbinden.

13. Luftfahrzeug, das einen Avionikraum umfasst, der aus einem Satz von Gehäusestrukturen nach einem beliebigen der Ansprüche 5 bis 11 besteht, **dadurch gekennzeichnet, dass** die Gehäusestrukturen (1) so auf mechanischen Strukturen angeordnet sind, dass eine Zirkulation von Luft zwischen ihnen möglich ist und Steuersignale über elektrische und/oder optische Kabelbäume an elektrische/elektronische Ausrüstungen des Luftfahrzeugs übertragen werden.

## Claims

1. A method for inserting, locking and extracting an electronic module (2) reversibly connected with a back panel (13) of a housing structure (1) configured with individual slots (10) for each of the electronic modules (2), this method wherein in that it consists in carrying out the following steps for locking each electronic module (2):
- introducing the electronic module (2) in an individual slot (10) until a start of pivoting of an effort gearing-down lever (3) is released and triggered by a mobile link (31) formed between a distal end (3d) of said gearing-down lever (3) mounted to rotate (30) on the back panel (13) and the electronic module (22, 22', 2);
- exerting a pressure on said lever (3) from a proximal end (3p) of this lever (3) to continue the pivoting of the lever (3), move the electronic module (2) against the back panel (13) by the orientation of the mobile link (22, 31) and connect the electronic module (2) to the back panel (13) by a transference of the insertion efforts in a connection interface;
- completing the pivoting of the lever (3) to reach a position of automatic locking of its proximal end (3p) by triggering a locking mechanism (4);
and, for the extraction of each electronic module (2):
- acting on the locking mechanism (4) to unlock the proximal end (3p) of the lever (3), pivot the lever (3) in the reverse direction of the locking direction to disconnect the electronic module (2) by transference of the uncoupling efforts in the connection interface, and advance the electronic module (2) in its slot (10) before removing the electronic module (2).

2. The method for inserting, locking and extracting as claimed in claim 1, wherein the locking and unlocking states of the lever (3) are validated by the appearance of different visual indications on the automatic locking mechanism (4).

3. The method for inserting, locking and extracting as claimed in either one of claims 1 and 2, wherein the mobile link between the distal end (3d) of the lever and the electronic module (22, 22'; 2) is formed by a guiding path (31).

4. The method for inserting, locking and extracting as claimed in any one of the preceding claims, wherein the lever arm (3) has an elasticity to achieve the locking while continuing to be lowered, even after connection.

5. A housing structure (1) for electronic modules (2) equipped with a system for inserting, locking and extracting such modules (2) for implementing the method as claimed in any one of the preceding claims, such a housing structure (1) comprising adjacent individual slots (10) separated by lateral runners (11) and a back panel (13) provided with wiring connectors (21), each slot (10) being intended to accommodate an electronic module (2), this structure is **characterized in that** the system for inserting, locking and extracting comprises a lever arm (3) for each individual slot (10) provided at a distal end (3d) with pivoting means (30) on the back panel (13) and guiding means (31) capable of cooperating with circulation means (22, 22') linked to the electronic module (2) to couple connectors (2C) of the electronic module (2) to the connectors (21) of the back panel (13), as well as means for locking/automatic unlocking in raised position (41 to 43) and for automatic locking/unlocking (40, 44, 45) in lowered position of a proximal end (3p) of each lever arm (3).

6. The housing structure as claimed in the preceding claim, wherein the locking and unlocking states of the lever arm (3) in lowered position are validated by a visual indicator via an aperture (45) formed on a beveled proximal end face (3b) of the lever arm (3) according to the position of the automatic locking mechanism (40) comprising a bolt (45) releasably coupled to the bottom plate (12) between a locking position an unlocking position.

7. The housing structure as claimed in either one of claims 5 and 6, wherein the locking/automatic unlocking mechanism (41 to 43) of the lever arm (3) in raised position comprises securing means (41 to 43) that can be released under pressure from a ball pushbutton (41).

8. The housing structure as claimed in any one of claims 5 to 7, wherein the lever arm (3) is made of a flexible material serving as elastic abutment for the protuberance (22, 22').

9. The housing structure as claimed in any one of claims 5 to 8, wherein the guiding means comprise a cam path (31) in which a protuberance (22, 22') can circulate, this protuberance (22, 22') being chosen between a snug, a pin and a roller.

10. The housing structure as claimed in any one of claims 5 to 9, wherein each lever arm (3) is composed of two branches intended to bracket each lateral face (2L) of an electronic module (2).

11. The housing structure as claimed in any one of claims 5 to 9, wherein the connectors (2C) of each module (2) and the connectors (21) of the back panel (13) are provided with foolproofing keys (20).

12. An aircraft avionics bay consisting of a set of housing structures (1) as claimed in any one of claims 5 to 11 and intended to connect electrical/electronic equipment via wiring distributed in the aircraft.

13. An aircraft comprising an avionics bay consisting of a set of housing structures as claimed in any one of claims 5 to 11, **characterized in that** the housing structures (1) are arranged on mechanical structures so as to allow a circulation of air between them and to transmit command signals to electrical/electronic equipment of the aircraft via electrical and/or optical wiring looms.
